# EUROPEAN PATENT APPLICATION

(11) **EP 4 481 814 A1**
(43) Date of publication of application: **25.12.2024**
(21) Application number: 24167592.5
(22) Date of filing: 28.03.2024
(51) Int. Cl.: H01L 25/075, H01L 25/16, H01L 33/20, H01L 33/62

(54) **DISPLAY DEVICE AND METHOD OF MANUFACTURING THE SAME**

(30) Priority: 19.06.2023 KR 20230078515
(71) Applicant: Samsung Display Co., Ltd., Yongin-si, Gyeonggi-do 17113 (KR)
(72) Inventor: SON, Kyung Rock, 17113 Yongin-si (KR); LEE, Gwang Geun, 17113 Yongin-si (KR); LEE, Jung An, 17113 Yongin-si (KR)
(74) Representative: Marks & Clerk LLP

(57) **Abstract**

A display device includes: a substrate; a connection electrode on the substrate; a light emitting element on the connection electrode and including a first semiconductor layer, an active layer, and a second semiconductor layer sequentially arranged in a third direction; and an insulating layer covering the connection electrode and the light emitting element. The insulating layer has openings spaced apart from each other and exposing the second semiconductor layer of the light emitting element, and the second semiconductor layer has a plurality of grooves corresponding to the openings in the insulating layer.

## Description

### BACKGROUND

### 1. Field

Aspects of embodiments of the present disclosure relate to a display device and a method of manufacturing the same.

### 2. Description of the Related Art

Recently, as interest in an information display has increased, and research and development on a display device has been continuously conducted.

### SUMMARY

Embodiments of the present disclosure provide a display device exhibiting increased light emission efficiency of light emitted from a light emitting element by forming a concavo-convex pattern on one surface of the light emitting element from which light is emitted and a method of manufacturing the same.

Embodiments of the present disclosure also provide a method of manufacturing a display device exhibiting increased process efficiency and reduced cost by performing a process of forming the concavo-convex pattern of the light emitting element together with (or simultaneously with) a process of forming a pixel circuit area after disposing the light emitting element on a substrate.

However, aspects and features of the present disclosure are not limited to the above-described aspects and features, and they may be variously expanded without departing from the scope of the present disclosure.

According to an embodiment of the present disclosure, a display device includes a substrate, a connection electrode on the substrate, a light emitting element on the connection electrode and including a first semiconductor layer, an active layer, and a second semiconductor layer sequentially arranged in a third direction, and an insulating layer covering the connection electrode and the light emitting element. The insulating layer has openings spaced apart from each other and exposing the second semiconductor layer of the light emitting element, and the second semiconductor layer has a plurality of grooves corresponding to the openings.

According to an embodiment, each of the plurality of grooves may overlap the openings in a plan view.

According to an embodiment, the plurality of grooves may extend through a portion of the second semiconductor layer.

According to an embodiment, the openings in the insulating layer and the plurality of grooves of the second semiconductor layer may form a concavo-convex pattern.

According to an embodiment, the display device may further include a first transistor on the substrate and spaced apart from the light emitting element in a first direction crossing the third direction.

According to an embodiment, the display device may further include a first pixel electrode on the insulating layer and electrically connected to the first semiconductor layer of the light emitting element through the connection electrode and a second pixel electrode. The insulating layer may have a contact opening exposing a portion of the second semiconductor layer in which the plurality of grooves are not disposed, and the second pixel electrode may be electrically connected to the second semiconductor layer of the light emitting element through the contact opening.

According to an embodiment, the first pixel electrode may be between the first transistor and the light emitting element.

According to an embodiment, the first pixel electrode may not overlap the light emitting element in a plan view, and the second pixel electrode may be on the insulating layer and may cover at least one side surface of the light emitting element.

According to an embodiment, the display device may further include a second power line on the same layer as the connection electrode and to which second driving power is applied.

According to an embodiment, the display device may further include a first via layer covering the first transistor and the second power line and a second conductive pattern on the first via layer and connected to the first transistor.

According to an embodiment, the display device may further include a second via layer on the first via layer and covering the second conductive pattern and a third conductive pattern on the second via layer. The third conductive pattern may include a first power line to which first driving power is applied.

According to an embodiment, an inner surface shape of each of the plurality of grooves may be a taper.

According to an embodiment, the display device may further include a conductive adhesive member between the connection electrode and the light emitting element.

According to another embodiment of the present disclosure, a method of manufacturing a display device includes providing a substrate having a display element area and a pixel circuit area, forming a first transistor in the pixel circuit area, forming a connection electrode in the display element area, forming a light emitting element by sequentially forming a first semiconductor layer, an active layer, and a second semiconductor layer on the connection electrode, forming an insulating layer covering the first transistor, the connection electrode, and the light emitting element, forming openings partially exposing the second semiconductor layer of the light emitting element by etching the insulating layer, forming a first conductive layer on the first transistor, and forming first conductive patterns by etching the first conductive layer. The forming of the first conductive patterns includes forming first grooves in the second semiconductor layer exposed through the openings.

According to an embodiment, the forming of the openings may include forming a first contact hole and a second contact hole for exposing a source electrode and a drain electrode of the first transistor, respectively, by etching the insulating layer.

According to an embodiment, the method may further include forming a contact opening exposing the second semiconductor layer of the light emitting element by etching the insulating layer. The first conductive patterns may include a first pixel electrode electrically connected to the first semiconductor layer of the light emitting element through the connection electrode and a second pixel electrode electrically connected to the second semiconductor layer of the light emitting element through the contact opening.

According to an embodiment, the method may further include forming a first via layer on the first conductive patterns, forming a second conductive layer on the first via layer, and forming second conductive patterns by etching the second conductive layer. The forming of the second conductive patterns may include forming second grooves in the second semiconductor layer exposed through the openings, the first grooves may have a first etch depth, and the second grooves may have a second etch depth deeper than the first etch depth.

According to an embodiment, the forming of the first conductive patterns may include etching the first conductive layer by using an etching gas, and the forming of the second conductive pattern may include etching the second conductive layer by using the etching gas.

According to an embodiment, the etching gas may include boron trichloride (BCl₃) and chlorine (CL₂).

According to an embodiment, the second conductive patterns may include a (2-1)-th conductive pattern and a (2-2)-th conductive pattern, and the (2-1)-th conductive pattern may include a scan line.

According to an embodiment, the method may further include forming a second via layer on the first via layer, forming a third conductive layer on the second via layer, and forming a third conductive pattern by etching the third conductive layer by using the etching gas. The forming of the third conductive pattern may include forming third grooves in the second semiconductor layer exposed through the openings, and the third grooves may have a third etch depth deeper than the second etch depth.

According to an embodiment, the third conductive pattern may include a first power line to which first driving power is applied, and the third conductive pattern may be electrically connected to a second terminal of the first transistor through the (2-2)-th conductive pattern.

The display device and the method of manufacturing the display device, according to embodiments of the present disclosure, may increase light extraction efficiency by forming a concavo-convex pattern on a surface of a light emitting element from which light is emitted.

In addition, the concavo-convex pattern formed on one surface of the light emitting element from which light is emitted may not be formed in a separate process step and may be formed in a process of forming a pixel circuit. Accordingly, because a separate process step (including time and process conditions) for forming the concavo-convex pattern may be omitted, process efficiency may be increased and a manufacturing process cost may be reduced.

However, aspects and features of the present disclosure are not limited to the above-described aspects and features, and they may be variously expanded without departing from the scope of the present disclosure.

At least some of the above and other features of the invention are set out in the claims.

### BRIEF DESCRIPTION OF THE DRAWINGS

FIG. 1 is a schematic plan view illustrating a display device according to embodiments of the present disclosure;
FIG. 2 is a circuit diagram illustrating a sub-pixel included in the display device shown in FIG. 1 according to an embodiment of the present disclosure;
FIG. 3 is a cross-sectional view illustrating a light emitting element included in the sub-pixel shown in FIG. 2 according to an embodiment of the present disclosure;
FIG. 4 is a cross-sectional view of a sub-pixel including the light emitting element shown in FIG. 3 according to an embodiment of the present disclosure;
FIG. 5 is an enlarged view illustrating the area A of FIG. 4 according to an embodiment of the present disclosure; and
FIGS. 6 to 17 are schematic cross-sectional views illustrating steps of a method of manufacturing a display device according to embodiments of the present disclosure.

### DETAILED DESCRIPTION

Hereinafter, embodiments of the present disclosure will be described in more detail with reference to the accompanying drawings.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

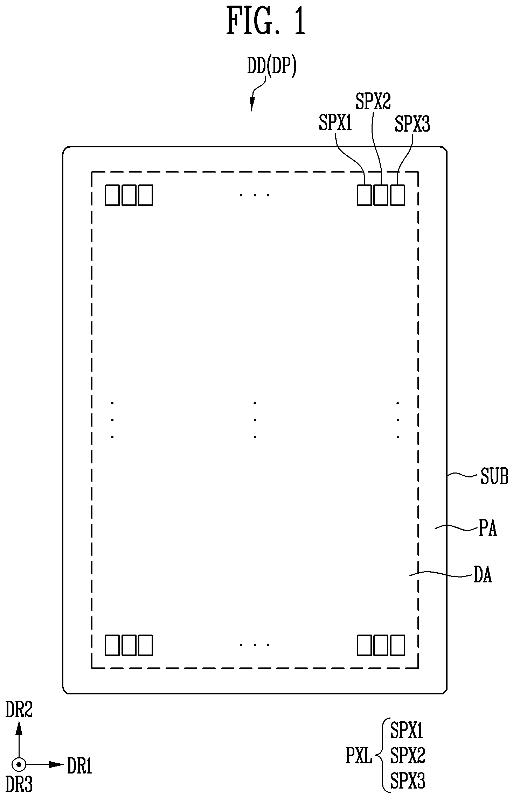

FIG. 1 is a schematic plan view illustrating a display device according to embodiments of the present disclosure.

Referring to FIG. 1, a display panel DP (or a display device DD) may be provided in various shapes, for example, a rectangular plate shape having two pairs of sides parallel to each other, but it is not limited thereto. When the display panel DP has a rectangular plate shape, one pair of sides from among the two pairs of sides may be longer than the other pair of sides.

At least a portion of the display panel DP may be flexible and may be folded at a flexible portion, but it is not limited thereto.

The display panel DP may display an image. The display panel DP may be a display panel capable of (or configured for) self-emission (e.g., may be a self-emissive display panel), such as an organic light emitting diode (OLED) display panel (or OLED panel) using an organic light emitting diode as a light emitting element, an ultra-small light emitting diode display panel (micro-LED or nano-LED display panel) using an ultra-small light emitting diode as a light emitting element, and a quantum dot organic light emitting display panel (QD OLED panel) using a quantum dot and an organic light emitting diode. In addition, the display panel DP may be a non-emission (or non-self emissive) display panel, such as a liquid crystal display panel (LCD panel), an electro-phoretic display panel (EPD panel), and an electro-wetting display panel (EWD panel). When the display panel DP is the non-emission display panel, the display device DD may include a backlight unit for supplying light to the display panel DP. However, the present disclosure is not limited thereto, and the display panel DP may include an inorganic light emitting element having an inorganic semiconductor.

The display panel DP may include a substrate SUB and pixels PXL provided on the substrate SUB.

The substrate SUB may include a transparent insulating material to transmit light. The substrate SUB may be a rigid substrate or a flexible substrate. The rigid substrate may be, for example, one of a glass substrate, a quartz substrate, a glass ceramic substrate, and a crystalline glass substrate.

The flexible substrate may be one of a film substrate and a plastic substrate including a polymeric organic material. For example, the flexible substrate may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, triacetate cellulose, and cellulose acetate propionate.

The display device DD may have various shapes. For example, the display device DD may have a rectangular shape, but it is not limited thereto. For example, the display device DD may have a circular or elliptical shape. In addition, the display device DD may include an angled corner and/or a curved corner. For convenience, in FIG. 1, the display device DD having a rectangular plate shape is shown as an example. In addition, in FIG. 1, an extension direction of a short side of the display device DD (for example, a horizontal direction) is indicated as a first direction DR1, and an extension direction of a long side (for example, a vertical direction) is indicated as a second direction DR2.

The substrate SUB (and the display device DD) may have a display area DA for displaying an image and a peripheral area PA (or a non-display area) excluding (or other than) the display area DA. The substrate SUB may have (or may define) the display area DA including pixel areas where each pixel PXL is disposed and a peripheral area PA disposed around (or adjacent to) the display area DA.

The peripheral area PA may be positioned adjacent to the display area DA. The peripheral area PA may be provided on at least one side of the display area DA. For example, the peripheral area PA may surround a circumference (or an edge or periphery) of the display area DA. In an embodiment, the peripheral area PA may be a bezel area of the display device DD.

A pixel PXL may be disposed in the display area DA on the substrate SUB. The peripheral area PA may be disposed around the display area DA. The peripheral area PA may have a structure for protecting the pixels PXL and associated components disposed in the display area DA, but it is not limited thereto. For example, a line unit connected to each pixel PXL and a driver connected to the line unit and driving the pixel PXL may be provided in the peripheral area PA.

The pixel PXL may include a plurality of pixels (or sub-pixels) SPX1 to SPX3. For example, the pixel PXL may include a first sub-pixel SPX1, a second sub-pixel SPX2, and a third sub-pixel SPX3. The first sub-pixel SPX1, the second sub-pixel SPX2, and the third sub-pixel SPX3 may be sequentially disposed in the first direction DR1. However, the present disclosure is not limited thereto, and the first sub-pixel SPX1, the second sub-pixel SPX2, and the third sub-pixel SPX3 may be sequentially disposed in the second direction DR2 crossing the first direction DR1.

The first to third sub-pixels SPX1 to SPX3 may emit light having different colors. For example, the first sub-pixel SPX1 may be a red sub-pixel for emitting red light, the second sub-pixel SPX2 may be a green sub-pixel for emitting green light, and the third sub-pixel SPX3 may be a blue sub-pixel for emitting blue light. However, a color, a type, the number, and/or the like of the pixels (or sub-pixels) configuring the pixel PXL are/is not particularly limited. For example, colors of the light emitted from each of the first to third sub-pixels SPX1 to SPX3 may be variously changed.

Hereinafter, when the first to third sub-pixels SPX1 to SPX3 are comprehensively named, the first to third sub-pixels SPX1 to SPX3 are referred to as the pixel PXL.

A plurality of pixels PXL may be provided and may be arranged in a matrix form along a row extending in the first direction DR1 and a column extending in the second direction DR2. An arrangement form of the pixels PXL is not particularly limited, and when the plurality of pixels PXL are provided, the plurality of pixels PXL may be provided to have different areas (or sizes). For example, in an embodiment in which the pixels PXL (or sub-pixels) emit different colors of emitted light, the pixels PXL (or sub-pixels) may be provided in different areas (or sizes) or may have different shapes for each color.

The driver may control driving of the pixel PXL by providing a signal and power (e.g., a predetermined signal and a predetermined power) to each pixel PXL through the line unit.

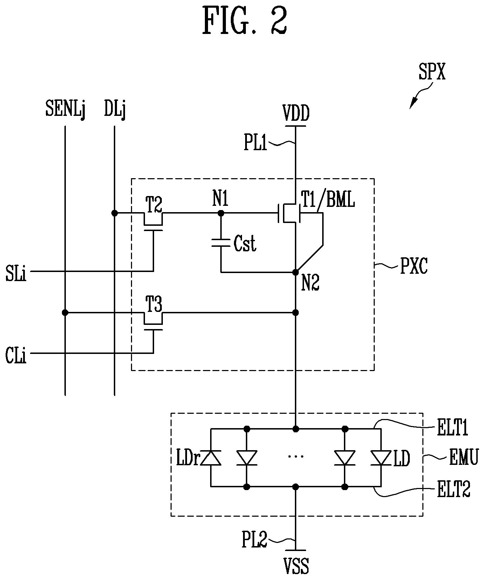

FIG. 2 is a circuit diagram illustrating a sub-pixel included in the display device shown in FIG. 1 according to an embodiment of the present disclosure.

The sub-pixel SPX shown in FIG. 2 may be any one of the sub-pixels SPX1 to SPX3 shown in FIG. 1, and the sub-pixels SPX1 to SPX3 arranged in the display area of each display device DD may be configured substantially identically or similarly to each other.

In FIG. 2, for convenience, a sub-pixel SPX positioned in an i-th pixel row (or an i-th horizontal line) and a j-th pixel column is shown (where i and j are natural numbers).

Referring to FIG. 2, the sub-pixel SPX may include a light emitting unit EMU that generates light having a luminance corresponding to a data signal. In addition, the sub-pixel SPX may selectively further include a pixel circuit PXC for driving the light emitting unit EMU.

The light emitting unit EMU may include a plurality of light emitting elements LD connected in parallel between a first power line PL1 connected to first driving power VDD to which a voltage of the first driving power VDD is applied and a second power line PL2 connected to second driving power VSS to which a voltage of the second driving power VSS is applied. For example, the light emitting unit EMU may include a first pixel electrode ELT1 connected to the first driving power VDD via the pixel circuit PXC and the first power line PL1, a second pixel electrode ELT2 connected to the second driving power VSS through the second power line PL2, and a plurality of light emitting elements LD connected in parallel in the same direction between the first and second pixel electrodes ELT1 and ELT2. In an embodiment, the first pixel electrode ELT1 may be an anode, and the second pixel electrode ELT2 may be a cathode.

Each of the light emitting elements LD included in the light emitting unit EMU may have one end connected to the first driving power VDD through the first pixel electrode ELT1 and another end connected to the second driving power VSS through the second pixel electrode ELT2. The first driving power VDD and the second driving power VSS may have different potentials. For example, the first driving power VDD may be set to a high-potential power, and the second driving power VSS may be set to a low-potential power. A potential difference between the first driving power VDD and the second driving power VSS may be set to be greater than or equal to a threshold voltage of the light emitting elements LD during an emission period of the pixel PXL.

As described above, each of the light emitting elements LD connected in parallel in the same direction (for example, a forward direction) between the first pixel electrode ELT1 and the second pixel electrode ELT2 to which voltages of different power are supplied may configure each effective light source.

In an embodiment, the light emitting elements LD of the light emitting unit EMU may emit light having a luminance corresponding to a driving current supplied through a corresponding pixel circuit PXC. For example, during each frame period, a driving current corresponding to a grayscale value of corresponding frame data of the pixel circuit PXC may be supplied to the light emitting unit EMU. The driving current supplied to the light emitting unit EMU may be divided and may flow to each of the light emitting elements LD. Accordingly, while each light emitting element LD emits light having a luminance corresponding to a current flowing therethrough, the light emitting unit EMU may emit light having the luminance corresponding to the driving current.

In the above-described embodiment, both ends of the light emitting elements LD are connected in the same direction between the first driving power VDD and the second driving power VSS, but the present disclosure is not limited thereto. According to an embodiment, the light emitting unit EMU may further include at least one non-effective light source, for example, a reverse light emitting element LDr, in addition to the light emitting elements LD configuring each effective light source. The reverse light emitting element LDr may be connected in parallel between the first and second pixel electrodes ELT1 and ELT2 together with the light emitting elements LD configuring the effective light sources and may be connected between the first and second pixel electrodes ELT1 and ELT2 in a direction opposite to the light emitting elements LD. The reverse light emitting element LDr maintains an inactive state even though a driving voltage (for example, a forward driving voltage) is applied between the first and second pixel electrodes ELT1 and ELT2, and thus, a current substantially does not flow through the reverse light emitting element LDr.

The pixel circuit PXC may be connected to a scan line SLi and a data line DLj of the pixel PXL. In addition, the pixel circuit PXC may be connected to a control line CLi and a sensing line SENLj of the pixel PXL. For example, when the pixel PXL is disposed in an i-th row and a j-th column in the display area DA, the pixel circuit PXC of the pixel PXL may be connected to the i-th scan line SLi, the j-th data line DLj, the i-th control line CLi, and the j-th sensing line SENLj.

The above-described pixel circuit PXC may include first to third transistors T1 to T3 and a storage capacitor Cst.

The first transistor T1 may be a driving transistor for controlling a driving current applied to the light emitting unit EMU and may be connected between the first driving power VDD and the light emitting unit EMU. A first terminal of the first transistor T1 may be connected to (or access) the first driving power VDD through the first power line PL1, a gate electrode of the first transistor T1 may be connected to a first node N1 and a second terminal of the first transistor T1 may be connected to a second node N2. The first transistor T1 may control an amount of the driving current applied from the first driving power VDD to the light emitting unit EMU through the second node N2 according to a voltage applied to the first node N1. In an embodiment, the first terminal of the first transistor T1 may be a drain electrode, and the second terminal of the first transistor T1 may be a source electrode, but the present disclosure is not limited thereto. According to an embodiment, the first terminal may be a source electrode and the second terminal may be a drain electrode.

In an embodiment, the first transistor T1 may selectively further include a bottom metal layer BML (or a back gate electrode). A gate electrode of the first transistor T1 and the bottom metal layer BML may overlap each other with a gate insulating layer interposed therebetween. In an embodiment, the bottom metal layer BML may be connected to one electrode, for example, the source electrode of the first transistor T1.

In an embodiment in which the first transistor T1 includes the bottom metal layer BML, a back-biasing technology (or a sync technology) of moving a threshold voltage of the first transistor T1 in a negative direction or a positive direction by applying a back-biasing voltage to the bottom metal layer BML of the first transistor T1 may be applied. In addition, when the bottom metal layer BML is disposed under a semiconductor pattern configuring (or forming) a channel of the first transistor T1 to block light incident to the semiconductor pattern, an operation characteristic of the first transistor T1 may be stabilized.

The second transistor T2 may be a switching transistor that selects the pixel PXL in response to a scan signal and activates the pixel PXL and may be connected between the data line DLj and the first node N1. A first terminal of the second transistor T2 may be connected to the data line DLj, a second terminal of the second transistor T2 may be connected to the first node N1, and a gate electrode of the second transistor T2 may be connected to the scan line SLi. The first terminal and the second terminal of the second transistor T2 may be different terminals, and for example, when the first terminal is a drain electrode, a second terminal may be a source electrode.

The second transistor T2 may be turned on when a scan signal of a gate-on voltage (for example, a high level voltage) is supplied from the scan line SLi, to electrically connect the data line DLj and the first node N1. The first node N1 may be a point at where the second terminal of the second transistor T2 and the gate electrode of the first transistor T1 are connected, and the second transistor T2 may transfer a data signal to the gate electrode of the first transistor T1.

The third transistor T3 may obtain a sensing signal through the sensing line SENLj by connecting the first transistor T1 to the sensing line SENLj and may detect a characteristic of the pixel PXL, including the threshold voltage of the first transistor T1, by using the sensing signal. Information on the characteristic of the pixel PXL may be used to convert image data so that a characteristic deviation between the pixels PXL may be compensated. A second terminal of the third transistor T3 may be connected to the second terminal of the first transistor T1, a first terminal of the third transistor T3 may be electrically connected to the sensing line SENLj, and a gate electrode of the third transistor T3 may be connected to the control line CLi. In addition, the first terminal of the third transistor T3 may be connected to initialization power. The third transistor T3 may be an initialization transistor capable of initializing the second node N2 and may be turned on when a sensing control signal is supplied from the control line SCi to transfer a voltage of the initialization power to the second node N2. Accordingly, a second storage electrode of the storage capacitor Cst connected to the second node N2 may be initialized.

A first storage electrode of the storage capacitor Cst may be connected to the first node N1, and the second storage electrode of the storage capacitor Cst may be connected to the second node N2. The storage capacitor Cst may charge a data voltage corresponding to the data signal supplied to the first node N1 during one frame period. Accordingly, the storage capacitor Cst may store a voltage corresponding to a difference between a voltage of the gate electrode of the first transistor T1 and a voltage of the second node N2.

In FIG. 2, an embodiment in which all light emitting elements LD configuring the light emitting unit EMU are connected in parallel is shown, but the present disclosure is not limited thereto. According to an embodiment, the light emitting unit EMU may be configured to include at least one serial stage (or stage) including a plurality of light emitting elements LD connected in parallel with each other. That is, the light emitting unit EMU may be configured in a series/parallel mixed structure.

In FIG. 2, all transistors T1 to T3 included in the pixel circuit PXC are n-type transistors, but the present disclosure is not limited thereto. For example, at least one of the transistors T1 to T3 may be changed to a p-type transistor.

In addition, a structure and a driving method of the sub-pixel SPX may be variously changed. For example, the pixel circuit PXC may be configured as a pixel circuit having various suitable structures and/or driving methods in addition to the embodiment shown in FIG. 2.

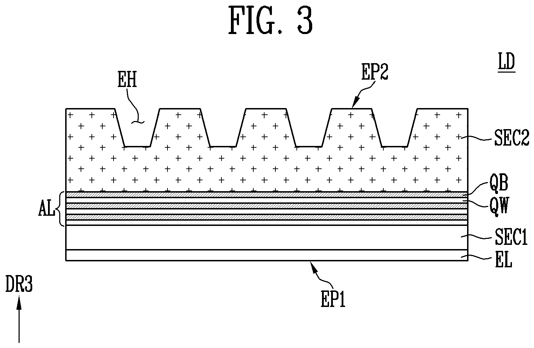

FIG. 3 is a cross-sectional view illustrating the light emitting element included in the sub-pixel shown in FIG. 2 according to an embodiment of the present disclosure.

Referring to FIG. 3, the light emitting element LD is configured to emit light. For example, the light emitting element LD may be a light emitting diode including an inorganic material.

The light emitting element LD may include a first semiconductor layer SEC1, an active layer AL, a second semiconductor layer SEC2, and an electrode layer EL. For example, when an extension direction (for example, a third direction DR3) of the light emitting element LD is a length direction, the electrode layer EL, the first semiconductor layer SEC1, the active layer AL, and the second semiconductor layer SEC2 may be implemented as a light emitting stack (or a stack pattern) sequentially stacked in the length direction.

The light emitting element LD may have a shape extending in one direction. The light emitting element LD may have a first end EP1 and a second end EP2 along the length direction. The first semiconductor layer SEC1 may be adjacent to the first end EP1 of the light emitting element LD, and the second semiconductor layer SEC2 may be adjacent to the second end EP2.

The light emitting element LD may have various shapes. For example, as shown in FIG. 1, the light emitting element LD may have a rod-like shape, a bar-like shape, or a column-like shape longer in a length L direction (e.g., having an aspect ratio greater than 1). In another embodiment, the light emitting element LD may have a rod-like shape, a bar-like shape, or a column-like shape shorter in the length direction (e.g., having an aspect ratio less than 1). In another embodiment, the light emitting element LD may have a rod-like shape, a bar-like shape, or a column-like shape having an aspect ratio of 1.

The light emitting element LD may include, for example, a light emitting diode (LED) manufactured in an ultra-small size having a diameter and/or a length of about nano scale (or nanometer) to micro scale (or micrometer).

When the light emitting element LD is relatively long in the length direction (that is, has an aspect ratio greater than 1), the diameter of the light emitting element LD may be in a range of about 0.5 µm to about 6 µm, and the length thereof may be in a range of about 1 µm to about 10 µm. However, the diameter and the length of the light emitting element LD are not limited thereto, and a size of the light emitting element LD may be changed to satisfy requirements (or a design condition) of a lighting device or a self-emitting display device to which the light emitting element LD is applied.

In an embodiment, the electrode layer EL may include a metal or a conductive metal oxide, and for example, the electrode layer EL may be formed of a transparent electrode material or the like, such as chromium (Cr), titanium (Ti), aluminum (Al), gold (Au), nickel (Ni), an oxide or an alloy thereof, indium tin oxide (ITO), indium zinc oxide (IZO), zinc oxide (ZnO), and indium tin zinc oxide (ITZO), alone or in combination. The electrode layer EL may be substantially transparent. Accordingly, light generated from the light emitting element LD may pass through the electrode layer EL and may be emitted to outside of the light emitting element LD.

In an embodiment, the electrode layer EL may have an upper surface on which the first semiconductor layer SEC1 is disposed and a first surface exposed to an outside in the length direction. The electrode layer EL may be the first end EP1 (e.g., a lower end) of the light emitting element LD.

The first semiconductor layer SEC1 may include, for example, at least one p-type semiconductor layer. For example, the first semiconductor layer SEC1 may include at least one semiconductor material from among InAlGaN, GaN, AlGaN, InGaN, AIN, and InN and may include a P-type semiconductor layer doped with a first conductivity-type dopant, such as Mg. The first semiconductor layer SEC1 may have a lower surface exposed to the outside along the length direction of the light emitting element LD and an upper surface contacting the active layer AL. The lower surface of the first semiconductor layer SEC1 may be the first end EP1 of the light emitting element LD.

The active layer AL may be disposed between the first semiconductor layer SEC1 and the second semiconductor layer SEC2 and may have a single or multiple quantum well structure. For example, when the active layer AL is formed in the multiple quantum well structure, in the active layer AL, a barrier layer QB and a well layer QW may be periodically repeatedly stacked as one unit. A strain reinforcing layer may be further included between the barrier layer QB and the well layer QW. The strain reinforcing layer may have a lattice constant less than that of the barrier layer QB to further reinforce strain applied to the well layer QW, for example, compressive strain. However, a structure of the active layer AL is not limited to the above-described embodiment.

A clad layer doped with a conductive dopant and/or a tensile strain barrier reducing (TSBR) layer may be further included on and/or under the active layer AL. For example, the clad layer may be formed of an AlGaN layer or an AlInGaN layer. The TSBR layer may be a strain relief layer disposed between semiconductor layers having different lattice structures and may act as a buffer for reducing a difference in a lattice constant. The TSBR layer may be configured as a p-type semiconductor layer, such as p-GaInP, p-AlInP, and p-AlGaInP, but is not limited thereto.

The active layer AL may emit light having a wavelength in a range of about 400 nm to about 900 nm and may have a double hetero structure. The active layer AL may have a first surface contacting the first semiconductor layer SEC1 and a second surface contacting the second semiconductor layer SEC2.

A color (or an emission color) of the light emitting element LD may be determined according to a wavelength of the light emitted from the active layer AL. The color of the light emitting element LD may determine a color of a pixel corresponding thereto. For example, the light emitting element LD may emit red light, green light, or blue light.

When an electric field of a reference (or predetermined) voltage or higher is applied to the both ends of the light emitting element LD, the light emitting element LD emits light when an electron-hole pair is coupled in the active layer AL. By controlling light emission of the light emitting element LD using such a principle, the light emitting element LD may be used as a light source (or a light emitting source) of various light emitting devices including a pixel of a display device.

In an embodiment, the second semiconductor layer SEC2 may include, for example, at least one n-type semiconductor layer. The second semiconductor layer SEC2 may include any one semiconductor material from among InAlGaN, GaN, AlGaN, InGaN, AIN, and InN and may include an n-type semiconductor layer doped with a second conductivity-type dopant, such as Si, Ge, or Sn. However, a material for forming the second semiconductor layer SEC2 is not limited thereto, and the second semiconductor layer SEC2 may be formed of various suitable materials. The second semiconductor layer SEC2 may have a lower surface contacting the active layer AL along the length direction of the light emitting element LD and an upper surface exposed to the outside. The upper surface of the second semiconductor layer SEC2 may be the second end EP2 of the light emitting element LD.

In an embodiment, the second end EP2 of the light emitting element LD may be a surface through which the light is emitted from the active layer AL. The upper surface of the second semiconductor layer SEC2 may have a plurality of grooves EH. The plurality of grooves EH may be disposed spaced apart from each other in a radial direction of the light emitting element LD. The upper surface of the second semiconductor layer SEC2 exposed to the outside may have a concavo-convex pattern formed by the plurality of grooves EH to increase light extraction efficiency of the light emitting element LD.

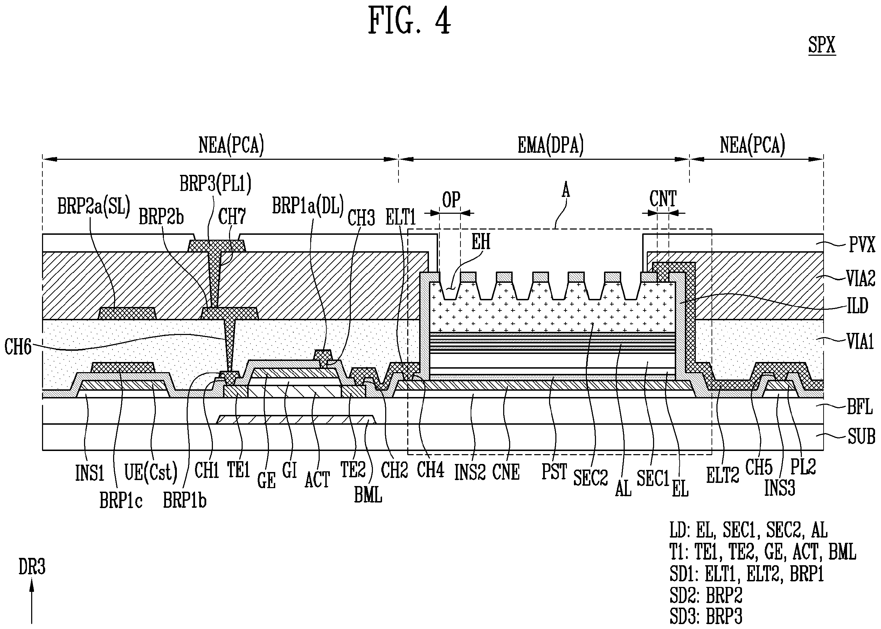

FIG. 4 is a cross-sectional view of a sub-pixel including the light emitting element shown in FIG. 3 according to an embodiment of the present disclosure.

Referring to FIG. 4, the display device may include the substrate SUB having (or defining) the display area (for example, the display area DA shown in FIG. 1). The sub-pixel SPX may be disposed in the display area. The sub-pixel SPX may include a pixel circuit area PCA and a display element area DPA.

The substrate SUB may configure (or may be) a base member of the display device DD. The substrate SUB may be a rigid or flexible substrate or film but is not limited thereto. According to an example, the substrate SUB may include polyimide. The substrate SUB may be provided as a base surface and may include the pixel circuit area PCA and the display element area DPA.

Circuit elements (for example, the first to third transistors T1 to T3 shown in FIG. 2) and signal lines electrically connected to the circuit elements may be disposed in the pixel circuit area PCA. Hereinafter, for convenience of description, the present disclosure is described based on the first transistor T1 from among the first to third transistors T1 to T3 described above.

The display element area DPA may be surrounded (e.g., may be surrounded along its periphery) by the pixel circuit area PCA. The display element area DPA may include the light emitting element LD for emitting light. The light emitting element may be, for example, an inorganic light emitting element including an inorganic light emitting material or a light emitting element that emits light by changing a wavelength of emitted light using a quantum dot, but it is not limited thereto.

The first transistor T1 may be disposed in the pixel circuit area PCA. The first transistor T1 may be disposed on one side of the light emitting element LD. The first transistor T1 may be disposed in a direction spaced apart from the light emitting element LD in a direction (for example, the first direction DR1 or the second direction DR2 of FIG. 1) crossing the third direction DR3. In an example, the first transistor T1 may include the gate electrode GE, the active layer ACT, the first and second terminals TE1 and TE2, and the bottom metal layer BML.

The bottom metal layer BML may be disposed on the substrate SUB and may be covered by a buffer layer BFL. A portion of the bottom metal layer BML may overlap other configurations of the first transistor T1. The bottom metal layer BML may include a conductive material and may provide a path through which an electrical signal provided to the pixel circuit area PCA and the display element area DPA moves. For example, the bottom metal layer BML may include any one of aluminum (Al), copper (Cu), titanium (Ti), and molybdenum (Mo).

The buffer layer BFL may be disposed on the substrate SUB. The buffer layer BFL may prevent an impurity from diffusing from the outside. The buffer layer BFL may include at least one of a metal oxide, such as silicon nitride (SiNₓ), silicon oxide (SiOₓ), silicon oxynitride (SiOₓN_{y}), and aluminum oxide (AlOₓ).

The active layer ACT may be disposed on the buffer layer BFL. For example, the active layer ACT may include any one of polysilicon, low temperature polycrystalline silicon (LTPS), amorphous silicon, and an oxide semiconductor. The active layer ACT may be a semiconductor layer. The active layer ACT may have a first contact area contacting the first terminal TE1 and a second contact area contacting the second terminal TE2. The first contact area and the second contact area may be a semiconductor pattern doped with an impurity. An area between the first contact area and the second contact area may be a channel area. The channel area may be an intrinsic semiconductor pattern that is not doped with an impurity.

In an embodiment, the first terminal TE1 may be electrically connected to the first power line PL1 through a (1-2)-th conductive pattern BRP1b and a (2-2)-th conductive pattern BPR2b. The second terminal TE2 may be electrically connected to the light emitting element LD through the first pixel electrode ELT1 and a connection electrode CNE. In an example, the first terminal TE1 may be a source electrode, and the second terminal TE2 may be a drain electrode.

The gate electrode GE may be disposed on a gate insulating layer GI. A position of the gate electrode GE may correspond to (e.g., may be aligned with) a position of the channel area of the active layer ACT. For example, the gate electrode GE may be disposed on the channel area of the active layer ACT with the gate insulating layer GI interposed therebetween. According to an example, the gate electrode GE may include any one of aluminum (Al), copper (Cu), titanium (Ti), and molybdenum (Mo). The gate insulating layer GI may be disposed on the active layer ACT.

In an embodiment, first to third insulating layers INS1 to INS3 may be directly disposed on the buffer layer BFL. In an example, the first to third insulating layers INS1 to INS3 may be sequentially disposed in a direction crossing the third direction DR3.

In an embodiment, the first and third insulating layers INS1 and INS3 may be disposed in the pixel circuit area PCA, and the second insulating layer INS2 may be disposed in the display element area DPA. In an example, the gate insulating layer GI may be disposed between the first and second insulating layers INS1 and INS2. The second insulating layer INS2 may be disposed between the gate insulating layer GI and the third insulating layer INS3.

One electrode (for example, the upper electrode UE) of the storage capacitor Cst may be disposed on the first insulating layer INS1.

The connection electrode CNE may be disposed on the second insulating layer INS2. The connection electrode CNE may be disposed in an area corresponding to the display element area DPA. That is, the connection electrode CNE may be disposed between the second insulating layer INS2 and the light emitting element LD. The connection electrode CNE may include a metal material having excellent reflectivity. For example, the connection electrode CNE may be formed of a material such as aluminum (Al), silver (Ag), silver alloy (Ag alloy), copper (Cu), or magnesium-silver alloy (Mg-Ag) but is not limited thereto.

The third insulating layer INS3 may be disposed in the pixel circuit area PCA adjacent to the display element area DPA. The second power line PL2 may be disposed on the third insulating layer INS3. The second power line PL2 may include a power line to which the voltage of the second driving power (for example, the second driving power VSS shown in FIG. 2) is applied.

The light emitting element LD may be disposed on the connection electrode CNE. The light emitting element LD may be disposed and/or provided in the display element area DPA. The light emitting element LD may be adhered to the connection electrode CNE through a conductive adhesive member PST. The conductive adhesive member PST may include conductive paste. The conductive paste may include silver.

The light emitting element LD may include the electrode layer EL, the first semiconductor layer SEC1, the active layer AL, and the second semiconductor layer SEC2. The electrode layer EL, the first semiconductor layer SEC1, the active layer AL, and the second semiconductor layer SEC2 may be sequentially stacked and disposed in the third direction DR3. In an example, the light emitted from the active layer AL may pass through the second semiconductor layer SEC2 and may be emitted in the third direction DR3. The second semiconductor layer SEC2 may have one surface having the plurality of grooves EH for increasing extraction efficiency of the light generated in the active layer AL.

The insulating layer ILD may cover one electrode of the storage capacitor Cst, the first transistor T1, the second power line PL2, and the light emitting element LD over the entire area of the pixel circuit area PCA and the display element area DPA.

In an embodiment, the insulating layer ILD may be disposed on a surface of the light emitting element LD disposed in the display element area DPL. The insulating layer ILD may be provided and/or formed to surround an outer circumferential surface of the first semiconductor layer SEC1, the active layer AL, the second semiconductor layer SEC2, and the electrode layer EL.

In an embodiment, the insulating layer ILD may have first to fifth contact holes (e.g., contact openings) CH1 to CH5, openings OP, and contact openings CNT. The first to fifth contact holes CH1 to CH5 may be provided and/or formed in the insulating layer ILD disposed in the pixel circuit area PCA. The openings OP and the contact opening CNT may be provided and/or formed in the insulating layer ILD disposed in the display element area DPA.

In an embodiment, the insulating layer ILD may cover the first transistor T1. The first to third contact holes CH1 to CH3 may be contact holes (e.g., contact openings) passing through the insulating layer ILD to expose the first transistor T1.

The insulating layer ILD may have the first contact hole CH1 exposing the first terminal TE1. The first terminal TE1 may be connected to the (1-2)-th conductive pattern BRP1b through the first contact hole CH1. The insulating layer ILD may have the second contact hole CH2 exposing the second terminal TE2. The second terminal TE2 may be electrically connected to the first pixel electrode ELT1 through the second contact hole CH2. The insulating layer ILD may have the third contact hole CH3 exposing the gate electrode GE. The (1-1)-th conductive pattern BRP1a may be electrically connected to the gate electrode GE through the third contact hole CH3. The (1-1)-th conductive pattern BRP1a may include a data line DL providing a data signal.

In an embodiment, the insulating layer ILD may cover the connection electrode CNE that does not overlap the light emitting element LD. The fourth contact hole CH4 may be a contact hole (e.g., a contact opening) exposing the connection electrode CNE. The connection electrode CNE may be electrically connected to the first pixel electrode ELT1 through the fourth contact hole CH4.

In an embodiment, the insulating layer ILD may cover one side surface of the light emitting element LD and the second power line PL2. The fifth contact hole CH5 may be a contact hole (e.g., a contact opening) exposing the second power line PL2. The second pixel electrode ELT2 may be electrically connected to the second power line PL2 through the fifth contact hole CH5 to receive the second driving power (for example, the second driving power VSS shown in FIG. 2). The contact opening CNT may be an opening exposing the second semiconductor layer SEC2 to electrically connect the second pixel electrode ELT2 and the light emitting element LD. The contact opening CNT may be filled with the second pixel electrode ELT2. The second driving power may be applied to the second semiconductor layer SEC2 through the second pixel electrode ELT2.

In an embodiment, the insulating layer ILD may cover a side surface and an upper surface of the light emitting element LD. The insulating layer ILD may have the openings OP exposing the second semiconductor layer SEC2 of the light emitting element LD. In an example, the plurality of grooves EH of the second semiconductor layer SEC2 may be exposed to the outside through the openings OP in the insulating layer ILD. That is, the plurality of grooves EH may overlap the openings OP in a cross-sectional view (or in a plan view).

In an embodiment, the openings OP may be formed in the same process as the first to fifth contact holes CH1 to CH5.

In an embodiment, the plurality of grooves EH may be formed in a process of forming circuit elements in the pixel circuit area PCA after the light emitting element LD is disposed in the display area DPA.

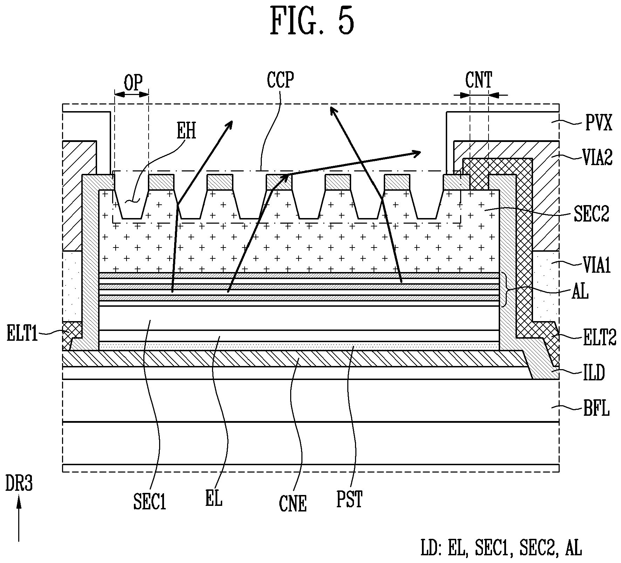

The display device, according to an embodiment of the present disclosure, may have the concavo-convex pattern (for example, the concavo-convex pattern CCP shown in FIG. 5) through the openings OP in the insulating layer ILD and the plurality of grooves EH in the second semiconductor layer SEC2. Accordingly, the light emitted from the active layer AL may pass through the concavo-convex pattern in a provided direction (e.g., in an emission direction), thereby increasing light emission efficiency of the light emitting element.

The insulating layer ILD may include a transparent insulating material. For example, the insulating layer ILD may include at least one insulating material selected from a group consisting of silicon oxide (SiOₓ), silicon nitride (SiNₓ), silicon oxynitride (SiOₓN_{y}), aluminum oxide (AlOₓ), titanium oxide (TiOₓ), hafnium oxide (HfOₓ), titanium strontium oxide (SrTiOₓ), cobalt oxide (CoₓO_{y}), magnesium oxide (MgO), zinc oxide (ZnOₓ), ruthenium oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InₓO_{y}:H, niobium oxide (NbₓO_{y}), magnesium fluoride (MgFₓ), aluminum fluoride (AlFₓ), an alucone polymer film (e.g., an organic-inorganic hybrid polymer film), titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), and vanadium nitride (VN), but the present disclosure is not limited thereto and various suitable materials having insulating properties may be used as the material of the insulating layer ILD.

In an embodiment, first to third conductive layers SD1 to SD3 may be disposed in the pixel circuit area PCA.

In an embodiment, the first conductive layer SD1 may be disposed on the insulating layer ILD. The first conductive layer SD1 may include the first pixel electrode ELT1, the second pixel electrode ELT2, and a first bridge pattern BRP1. The first pixel electrode ELT1, the second pixel electrode ELT2, and the first bridge pattern BRP1 may be disposed on the same layer.

The first pixel electrode ELT1 may be disposed between the first transistor T1 and the connection electrode CNE (or the light emitting element LD). The first pixel electrode ELT1 may not overlap the light emitting element LD in a cross-sectional view (or in a plan view). The first pixel electrode ELT1 may be disposed in the second contact hole CH2 and the fourth contact hole CH4. The first pixel electrode ELT1 may receive an anode signal from the second terminal TE2 through the second contact hole CH2. The first pixel electrode ELT1 may transfer the anode signal to the first end (for example, the first end EP1 shown in FIG. 3) of the light emitting element LD via the connection electrode CNE connected through the fourth contact hole CH4.

The second pixel electrode ELT2 may be disposed on the side surface of the light emitting element LD and on the fifth contact hole CH5. The second pixel electrode ELT2 may receive a cathode signal through the fifth contact hole CH5. The second pixel electrode ELT2 may transfer the cathode signal to the second end (for example, the second end EP2 shown in FIG. 3) of the light emitting element LD through the contact opening CNT.

In an embodiment, the first bridge pattern BRP1 may include a (1-1)-th conductive pattern BPR1a, a (1-2)-th conductive pattern BRP1b, and a (1-3)-th conductive pattern BRP1c. The (1-1)-th conductive pattern BRP1a may be disposed on the gate electrode GE and may be electrically connected to the gate electrode GE through the third contact hole CH3. The (1-1)-th conductive pattern BRP1a may include the data line DL to which the data signal is applied. The (1-2)-th conductive pattern BRP1b may be disposed on the first terminal TE1 and may be electrically connected to the first terminal TE1 through the first contact hole CH1. The (1-3)-th conductive patterns BRP1c may overlap one electrode of the storage capacitor Cst and may be disposed on the insulating layer ILD.

In an embodiment, a first via layer VIA1 may be disposed on the first conductive layer SD1. The first via layer VIA1 may be formed of an organic material to planarize a lower step difference. For example, the first via layer VIA1 may include an organic material, such as acrylic resin, epoxy resin, phenolic resin, polyamide resin, polyimide resin, polyester resin, polyphenylene sulfide resin, or benzocyclobutene (BCB). However, the present disclosure is not limited thereto, and the first via layer VIA1 may include various suitable types of inorganic materials, such as silicon oxide (SiOx), silicon nitride (SiNx), silicon oxynitride (SiOxNy), aluminum nitride (AlNx), aluminum oxide (AlOₓ), zirconium oxide (ZrOx), hafnium oxide (HfOx), or titanium oxide (TiOx).

In an embodiment, the second conductive layer SD2 may be disposed on the first via layer VIA1. The second conductive layer SD2 may include a second bridge pattern BRP2. The second bridge pattern BRP2 may include a (2-1)-th conductive pattern BRP2a and a (2-2)-th conductive pattern BRP2b. The (2-1)-th conductive pattern BRP2a and the (2-2)-th conductive pattern BRP2b may be disposed on the same layer and may be disposed spaced apart from each other on the first via layer VIA1. In an example, the (2-1)-th conductive pattern BRP2a may overlap the (1-3)-th conductive pattern BRP1c in a cross-sectional view (or in a plan view). The (2-1)-th conductive pattern BRP2a may include a scan line SL for supplying a scan signal. The (2-2)-th conductive pattern BPR2b may be electrically connected to the (1-2)-th conductive pattern BRP1b through a sixth contact hole CH6 passing through the first via layer VIA1.

In an embodiment, a second via layer VIA2 may be disposed on the first via layer VIA1. The second via layer VIA2 may cover the second conductive layer SD2. The second via layer VIA2 may be formed of an organic material to planarize a lower step difference. However, the present disclosure is not limited thereto, and the second via layer VIA2 may include various suitable types of inorganic materials.

In an embodiment, the third conductive layer SD3 may be disposed on the second via layer VIA2. The third conductive layer SD3 may include a third bridge pattern BRP3. The third bridge pattern BRP3 may be electrically connected to the (2-2)-th conductive pattern BRP2b through a seventh contact hole CH7 passing through the second via layer VIA2. The third bridge pattern BRP3 may include the first power line PL1 for supplying the first driving power (for example, the first driving power VDD shown in FIG. 1). The third bridge pattern BRP3 may supply the voltage of the first driving power VDD to the first terminal TE1 through the (2-2)-th conductive pattern BRP2b and the (1-2)-th conductive pattern BPR1b.

In an embodiment, a protective layer PVX may be disposed on the second via layer VIA2. The protective layer PVX may be formed of an organic material to planarize a lower step difference, but it is not limited thereto and may include various suitable types of inorganic materials. The protective layer PVX may have an opening exposing the light emitting element LD.

FIG. 5 is an enlarged view illustrating the area A of FIG. 4 according to an embodiment of the present disclosure.

Referring to FIG. 5, the first semiconductor layer SEC1 may be electrically connected to the first pixel electrode ELT1, and thus, the anode signal may be applied to the first semiconductor layer SEC1. The second semiconductor layer SEC2 may be electrically connected to the second pixel electrode ELT2 through the contact opening CNT in the insulating layer ILD, and thus, the cathode signal may be applied to the second semiconductor layer SEC2. When an electric field having a reference (or predetermined) voltage or higher is applied to the both ends of the light emitting element LD, light may be emitted when an electron-hole pair is coupled in the active layer AL. The light emitted from the active layer AL may pass through the second semiconductor layer SEC2 and may be emitted in the third direction DR3.

An exposed surface of the second semiconductor layer SEC2 may have a concavo-convex shape formed by the plurality of grooves EH. The plurality of grooves EH may be exposed to the outside in correspondence with (e.g., by being aligned with) the openings OP in the insulating layer ILD. A cross-sectional shape of the inner surface of each of the plurality of grooves EH may have a taper shape. In an example, a side surface and a protruding portion of the semiconductor layer SEC2 excluding the plurality of second grooves EH may be covered by the insulating layer ILD.

Because the display device according to an embodiment of the present disclosure may have a concavo-convex pattern CCP formed by the plurality of grooves EH and the openings OP, the display device may minimize (or improve) loss of a portion of the light emitted from the active layer AL.

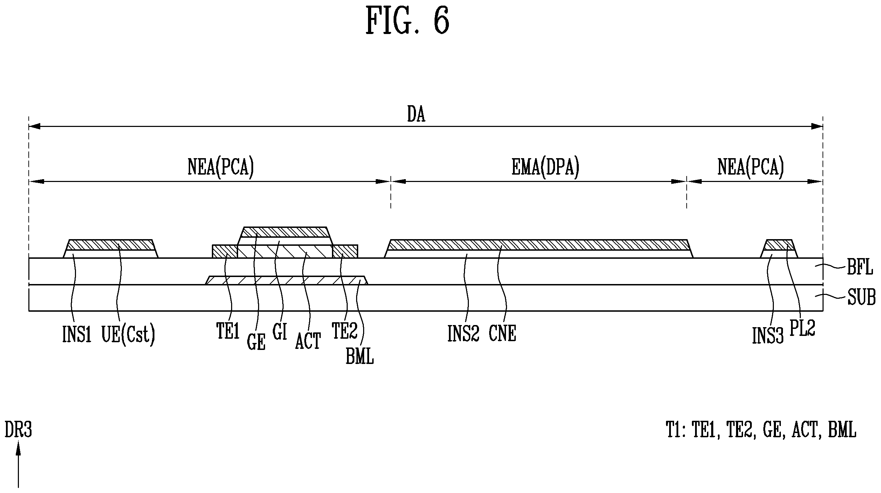

FIGS. 6 to 17 are schematic cross-sectional views illustrating steps of a method of manufacturing a display device according to embodiments of the present disclosure.

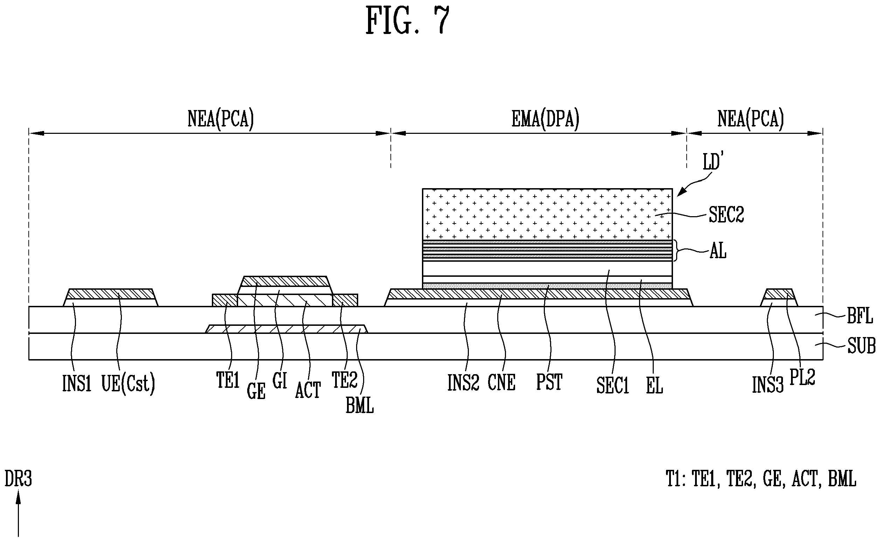

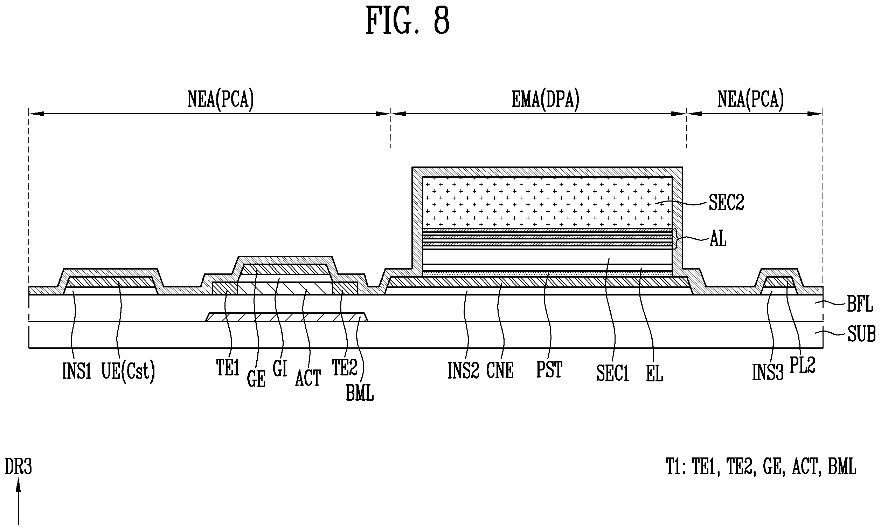

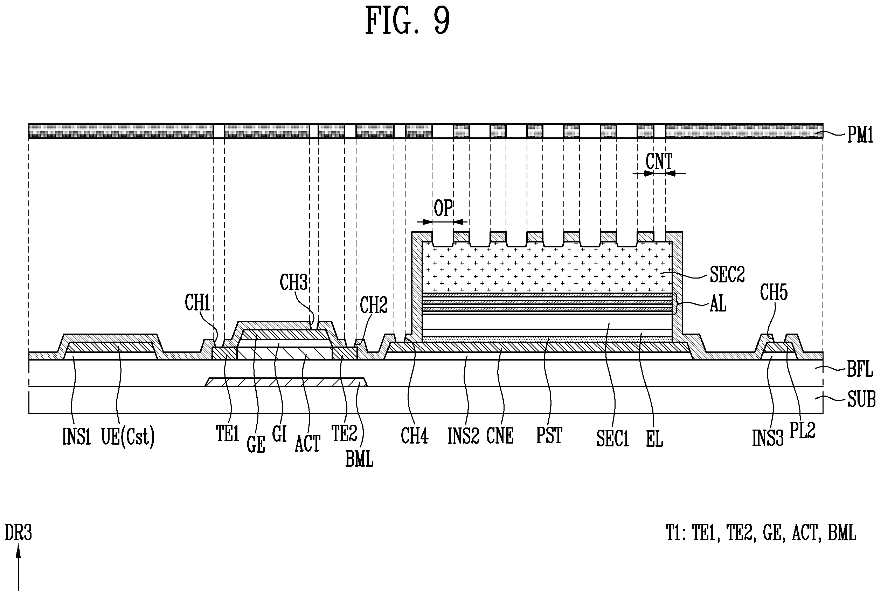

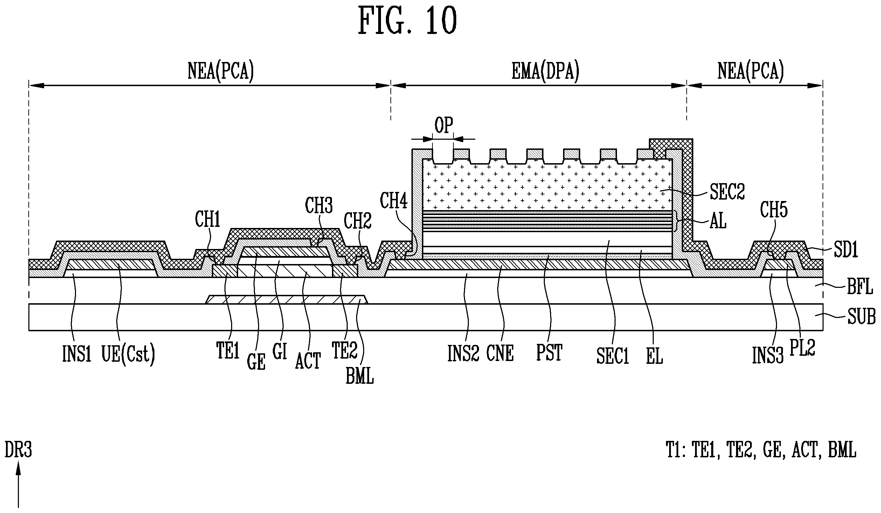

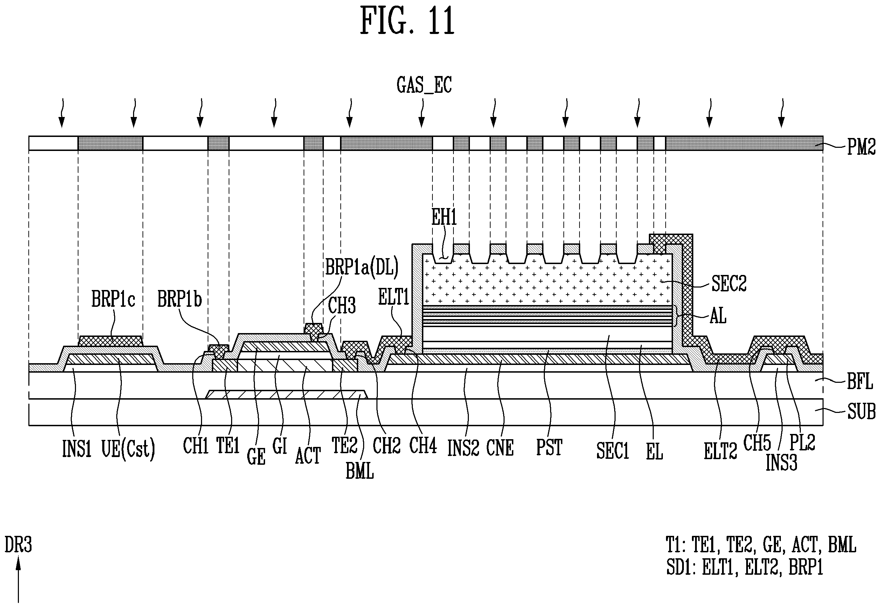

A method of manufacturing a display device according to an embodiment of the present disclosure may include forming the first transistor T1 and the connection electrode CNE on the substrate SUB (see, e.g., FIG. 6), forming a light emitting element LD' (see, e.g., FIG. 7) including the first semiconductor layer SEC1, the active layer AL, and the second semiconductor layer SEC2 sequentially disposed in the third directions DR3 on the connection electrode CNE (see, e.g., FIG. 7), forming the insulating layer ILD (see, e.g. described above with reference to FIG. 4) covering the first transistor T1, the connection electrode CNE, and the light emitting element LD (see, e.g., FIG. 8), forming the openings OP exposing the second semiconductor layer SEC2 of the light emitting element LD by etching the insulating layer ILD (see, e.g., FIG. 9), forming the first conductive layer SD1 on the first transistor T1 (see, e.g., FIG. 10), and forming the first conductive patterns ELT1, ELT2, and BRP1 by etching the first conductive layer SD1 (see, e.g., FIG. 11). Forming the first conductive patterns ETL1, ELT2, and BRP1 may include forming first grooves EH1 in the second semiconductor layer SEC2 exposed through the openings OP.

Referring to FIG. 6, the first transistor T1 and the connection electrode CNE may be formed in the display area DA on the substrate SUB. The first transistor T1 may be formed in the pixel circuit area PCA. The connection electrode CNE may be formed in the display element area DPA.

In an embodiment, the bottom metal layer BML may be formed on the substrate SUB. The buffer layer BFL may be formed on the substrate SUB to cover the bottom metal layer BML. The active layer ACT may be formed on the buffer layer BFL and may overlap the bottom metal layer BML in a cross-sectional view (or in a plan view).

In an embodiment, the gate insulating layer GI may be formed on the active layer ACT. The first to third insulating layers INS1 to INS3 may be spaced apart from each other and may be disposed on the buffer layer BFL. The first and second insulating layers INS1 and INS2 may be formed on both sides of the gate insulating layer GI. The third insulating layer INS3 may be formed on one side of the second insulating layer INS2. In an example, the gate insulating layer GI and the first to third insulating layers INS1 to INS3 may be formed of the same material formed in the same process.

In an embodiment, one electrode UE of the storage capacitor Cst may be formed on the first insulating layer INS1. The gate electrode GE may be formed on the gate insulating layer GI. The connection electrode CNE may be formed on the second insulating layer INS2. The second power line PL2 may be formed on the third insulating layer INS3. In an example, the one electrode UE of the storage capacitor Cst, the gate electrode GE, the connection electrode CNE, and the second power line PL2 may be formed of the same material in the same process. The one electrode UE of the storage capacitor Cst, the gate electrode GE, the connection electrode CNE, and the second power line PL2 may include a conductive material.

Referring to FIG. 7, the light emitting element LD' may be formed on the connection electrode CNE.

The light emitting element LD' may include the first semiconductor layer SEC1, the active layer AL, and the second semiconductor layer SEC2. The first semiconductor layer SEC1, the active layer AL, and the second semiconductor layer SEC2 may be sequentially stacked in the third direction DR3. The light emitting element LD' may include the second semiconductor layer SEC2 having a flat upper surface exposed in the third direction DR3.

The display area DA may include an emission area EMA and a non-emission area NEA (also shown in FIG. 4). The emission area EMA may correspond to an area at where the light emitting element LD' is disposed. The non-emission area NEA may correspond to an area at where the light emitting element LD' is not disposed.

The display element area DPA may be an area at where the light emitting element LD' is formed. The pixel circuit area PCA may be an area surrounding (e.g., surrounding a periphery of) the display element area DPA.

Referring to FIG. 8, the insulating layer ILD may be formed on the buffer layer BFL to cover the first transistor T1, the connection electrode CNE, and the light emitting element LD.

In an embodiment, the insulating layer ILD may be entirely formed over the pixel circuit area PCA and the display element area DPA.

Referring to FIG. 9, the insulating layer ILD may be etched, and thus, the openings OP and the contact opening CNT partially exposing the second semiconductor layer SEC2 of the light emitting element LD may be formed. In an example, one area of the insulating layer ILD corresponding to the first to fifth contact holes CH1 to CH5, the openings OP, and the contact opening CNT may be etched by using a first mask PM1. The insulating layer ILD may be etched, and thus, the first to fifth contact holes CH1 to CH5, the openings OP, and the contact opening CNT may be formed. The openings OP, the contact opening CNT, and the first to fifth contact holes CH1 to CH5 may be formed in the same process.

The first terminal TE1 (e.g., the source electrode) and the second terminal TE2 (e.g., drain electrode) of the first transistor T1 may be exposed through the first and second contact holes CH1 and CH2 passing through the insulating layer ILD. The gate electrode GE may be exposed through the third contact hole CH3. The connection electrode CNE may be exposed through the fourth contact hole CH4. The second power line PL2 may be exposed through the fifth contact hole CH5.

The second semiconductor layer SEC2 may be partially exposed through the openings OP and the contact opening CNT passing through the insulating layer ILD. The openings OP may define an area at where the plurality of grooves (for example, the plurality of grooves EH shown in FIG. 4) in the second semiconductor layer SEC2 are formed. The contact opening CNT2 may define an area at where the second pixel electrode (for example, the second pixel electrode ELT2 shown in FIG. 4) is formed.

Referring to FIG. 10, the first conductive layer SD1 (or first conductive patterns) may be formed in the pixel circuit area PCA. The first conductive layer SD1 may be formed on the insulating layer ILD disposed in the pixel circuit area PCA.

Referring to FIG. 11, the first conductive layer SD1 may be etched, and thus, the first conductive patterns ELT1, ELT2, and BRP1 may be formed.

In an embodiment, one area of the first conductive layer SD1 may be etched by exposing an etching gas GAS_EC on one area of the first conductive layer SD1 by passing it through a second mask PM2. The one area of the first conductive layer SD1 exposed to the etching gas GAS_EC may be removed. As the first conductive layer SD1 is etched, the first and second pixel electrodes ELT1 and ELT2 and the first bridge electrode BRP1 may be formed.

In an embodiment, the first pixel electrode ELT1 may be formed on the second and fourth contact holes CH2 and CH4. The second pixel electrode ELT2 may be formed on the contact opening CNT and the fifth contact hole CH5. The first bridge electrode BRP1 may include the (1-1)-th conductive pattern BRP1a, the (1-2)-th conductive pattern BRP2b, and the (1-3)-th conductive pattern BRP1c. The first conductive pattern BRP1a may be formed on the third contact hole CH3. The (1-2)-th conductive pattern BRP1b may be formed on the first contact hole CH1. The (1-3)-th conductive pattern BRP1c may be formed on the one electrode UE of the storage capacitor Cst.

In an embodiment, the first grooves EH1 may be formed in one surface of the second semiconductor layer SEC2 corresponding to the openings OP. In an example, the etching gas GAS_EC may be exposed on the second semiconductor layer SEC2 exposed through the openings OP. The second semiconductor layer SEC2 exposed to the etching gas GAS_EC may be etched, and thus, the first grooves EH1 may be formed. In an example, each of the first grooves EH1 may have a first etch depth.

In an embodiment, the first conductive patterns ELT1, ELT2, and BRP1 and the first grooves EH1 may be formed in the same process. In a process of etching the first conductive layer SD1 to form the first conductive patterns ELT1, ELT2, and BRP1, the etching gas GAS_EC may be exposed on the second semiconductor layer SEC2 exposed through the openings OP.

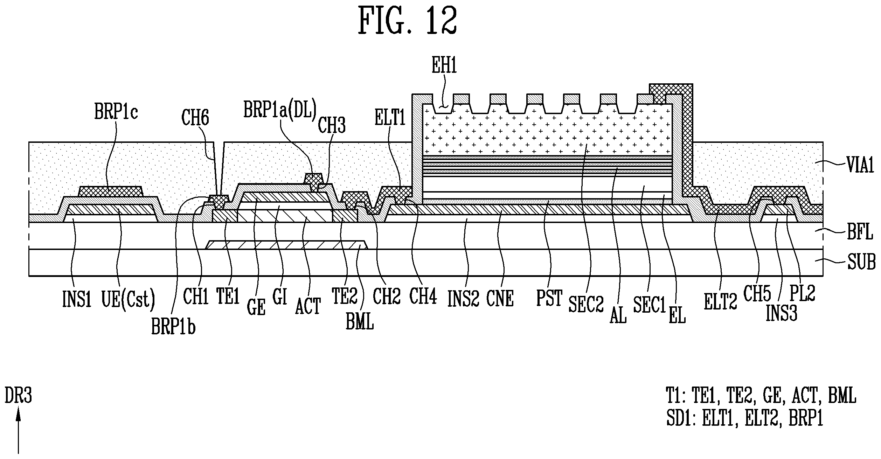

Referring to FIG. 12, the first via layer VIA1 may be formed on the first conductive patterns ELT1, ELT2, and BRP1. The first via layer VIA1 may be disposed to planarize a lower step difference. In an example, the sixth contact hole CH6 passing through the first via layer VIA1 may be formed.

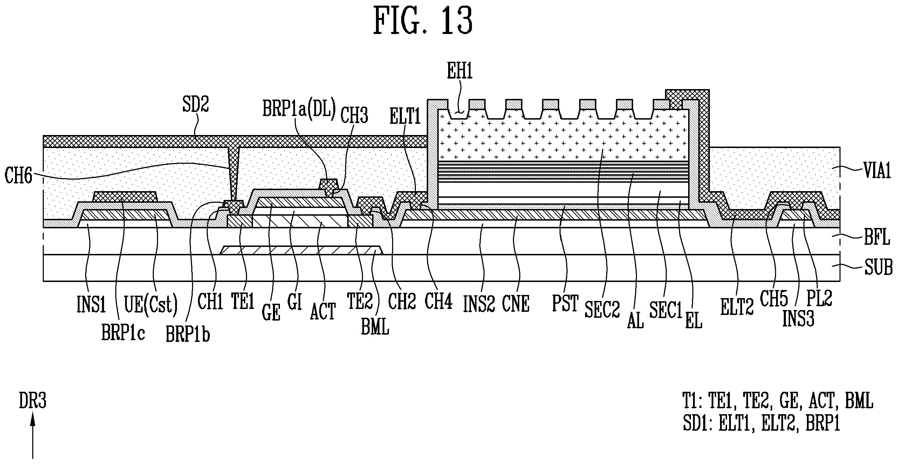

Referring to FIG. 13, the second conductive layer SD2 may be formed on the first via layer VIA1. In an example, the second conductive layer SD2 may overlap the first transistor T1 in a cross-sectional view (or in a plan view).

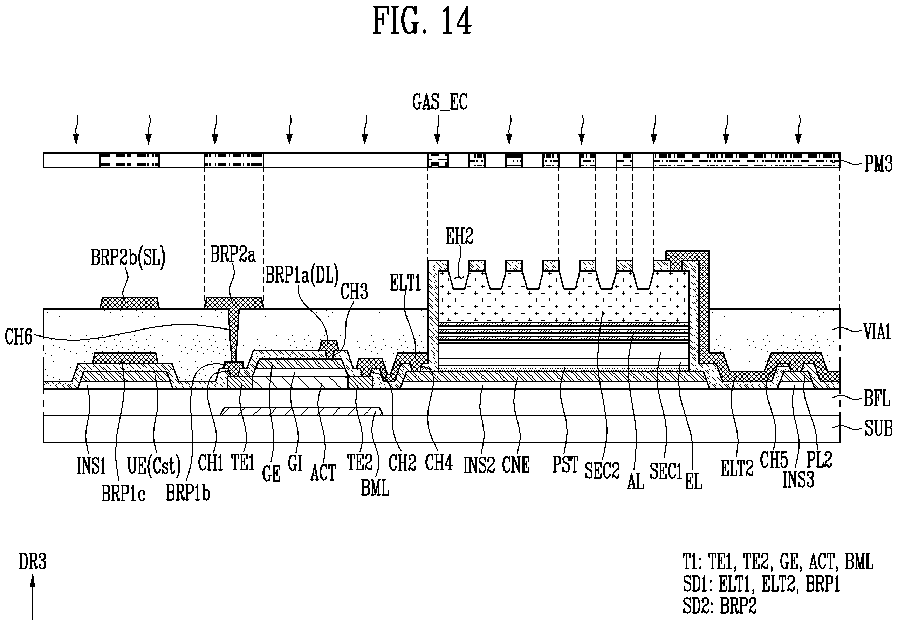

Referring to FIG. 14, the second conductive layer SD2 may be etched, and thus, the second conductive patterns BRP2 may be formed.

In an embodiment, as the etching gas GAS_EC is exposed on one area of the second conductive layer SD2 by passing it through a third mask PM3, the one area of the second conductive layer SD2 may be etched. The one area of the second conductive layer SD2 exposed to the etching gas GAS_EC may be removed. As the second conductive layer SD2 is etched, the second bridge pattern BRP2 may be formed.

In an embodiment, the second bridge pattern BRP2 may include the (2-1)-th conductive pattern BPR2a and the (2-2)-th conductive pattern BRP2b. The (2-1)-th conductive pattern BRP2a may be formed on the first via layer VIA1 and may overlap the (1-3)-th conductive pattern BRP1c. The (2-1)-th conductive pattern BPR2a may include the scan line SL for supplying the scan signal. The (2-2)-th conductive pattern BRP2b may be formed on the first via layer VIA1 and overlap the sixth contact hole CH6. The (2-2)-th conductive pattern BRP2b may be electrically connected to the (1-2)-th conductive pattern BRP1b through the sixth contact hole CH6.

In an embodiment, second grooves EH2 may be formed on one surface of the second semiconductor layer SEC2 corresponding to the openings OP. In an example, the etching gas GAS_EC may be exposed on the second semiconductor layer SEC2 exposed through the openings OP. The second semiconductor layer SEC2 exposed to the etching gas GAS_EC may be etched, and thus, the second grooves EH2 may be formed. In an example, as the etching gas GAS_EC is exposed on the first grooves EH1, a surface of the first grooves EH1 may be etched, and thus, the second grooves EH2 may be formed. Each of the second grooves EH2 may have a second etching depth. The second etch depth may be deeper than the first etch depth of the first grooves EH1 (see, e.g., FIG. 11).

In an embodiment, the second conductive patterns BRP2 and the second grooves EH2 may be formed in the same process. In a process of etching the second conductive layer SD2 to form the second conductive patterns BRP2, the etching gas GAS_EC may be exposed on the second semiconductor layer SEC2 exposed through the openings OP.

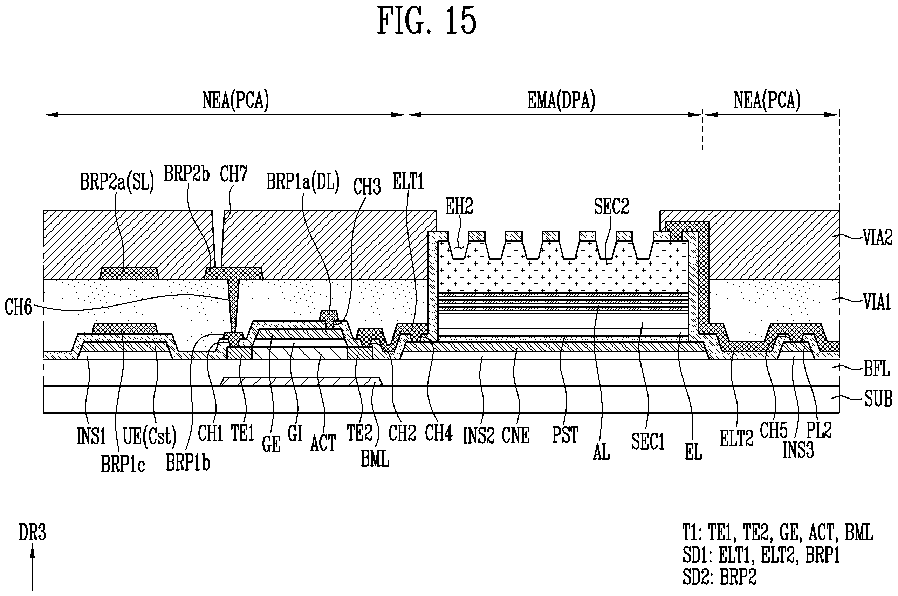

Referring to FIG. 15, the second via layer VIA2 may be formed on the first conductive patterns BRP2. The second via layer VIA2 may be disposed to planarize a lower step difference. In an example, the seventh contact hole CH7 passing through the second via layer VIA2 may be formed.

In an embodiment, the first and second via layers VIA1 and VIA2 may be formed in the pixel circuit area PCA.

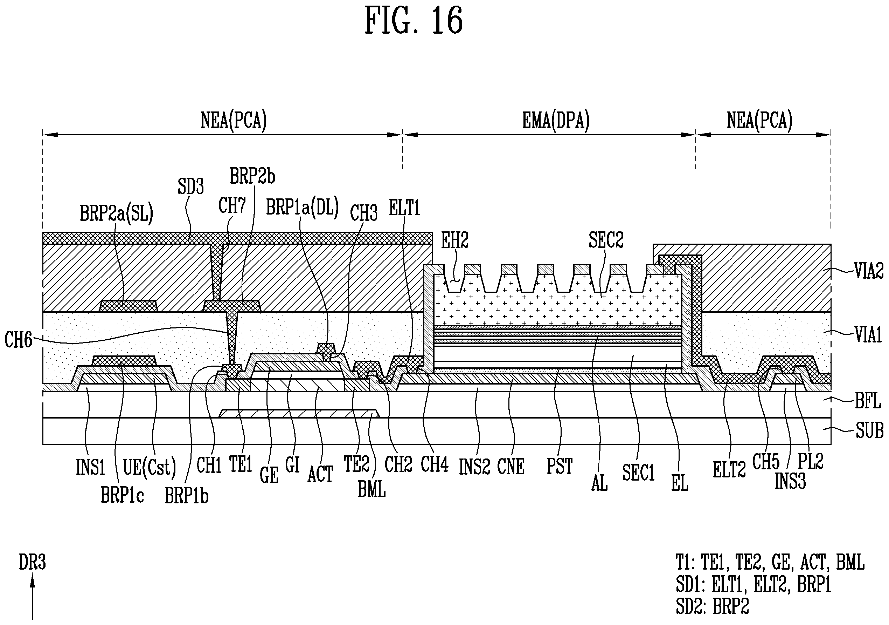

Referring to FIG. 16, the third conductive layer SD3 may be formed on the second via layer VIA2. In an example, the third conductive layer SD3 may be formed in the pixel circuit area PCA and may overlap the first transistor T1 and the (2-1)-th conductive pattern BRP2a in a cross-sectional view (or in a plan view).

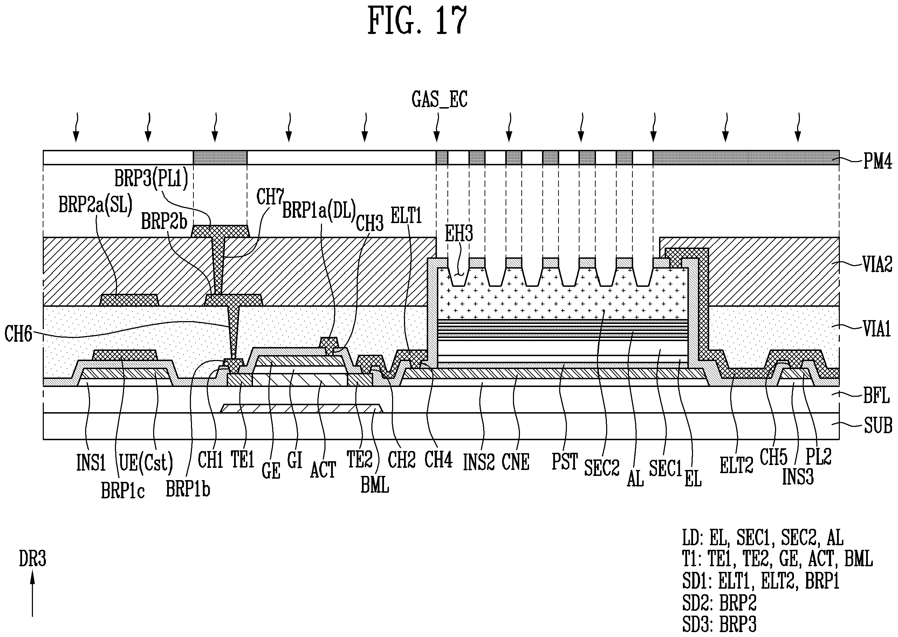

Referring to FIG. 17, the third conductive layer SD3 may be etched, and thus, the third conductive patterns BRP3 may be formed.

In an embodiment, as the etching gas GAS_EC is exposed on one area of the third conductive layer SD3 by passing it through a fourth mask PM4, the one area of the third conductive layer SD3 may be exposed. The one area of the third conductive layer SD3 exposed to the etching gas GAS_EC may be removed. As the third conductive layer SD3 is etched, the third bridge pattern BRP3 (e.g., the third conductive pattern) may be formed.

In an embodiment, the third bridge pattern BRP3 may be referred to as the third conductive pattern, and the third conductive pattern BRP3 may include the first power line PL1 for supplying the first driving power (for example, the first driving power VDD shown in FIG. 1). The third conductive pattern BPR3 may be formed on the second via layer VIA2 and may overlap the seventh contact hole CH7. The third conductive pattern BRP3 may be electrically connected to the (2-2)-th conductive pattern BRP2b through the seventh contact hole CH7. The third conductive pattern BRP3 may transfer the anode signal to the first terminal TE1 of the first transistor T1 through the (2-2)-th conductive pattern BRP2b and the (1-2)-th conductive pattern BRP1b.

In an embodiment, third grooves EH3 may be formed on one surface of the second semiconductor layer SEC2 corresponding to the openings OP. In an example, the etching gas GAS_EC may be exposed on the second semiconductor layer SEC2 exposed through the openings OP. The second semiconductor layer SEC2 exposed to the etching gas GAS_EC may be etched, and thus, the third grooves EH3 may be formed. In an example, as the etching gas GAS_EC is exposed on the second grooves EH2, a surface of the second grooves EH2 may be etched, and thus, the third grooves EH3 may be formed. In an example, each of the third grooves EH3 may have a third etch depth. The third etch depth may be deeper than the second etch depth of the second grooves EH2 (see, e.g., FIG. 14).

In an embodiment, the third conductive pattern BRP3 and the third grooves EH3 may be formed in the same process. In a process of etching the third conductive layer SD3 to form the third conductive pattern BRP3, the etching gas GAS_EC may be exposed on the second semiconductor layer SEC2 exposed through the openings OP.

In an embodiment, in a process of etching the first to third conductive layers SD1 to SD3, the etching gas GAS_EC may be exposed on the second semiconductor layer SEC2 exposed through the openings OP in the insulating layer ILD, and thus, the third grooves EH3 (or the plurality of grooves EH shown in FIG. 4) may be formed in the second semiconductor layer SEC2 corresponding to the openings OP.

Referring to FIGS. 11, 14, and 17, the etching gas GAS_EC may be used in the process of etching the first to third conductive layers SD1 to SD3. In an example, the etching gas GAS_EC may include boron trichloride (BCl₃) and chlorine (CL₂) but is not limited thereto. In an example, the second semiconductor layer SEC2 of the light emitting element LD may be etched by using the etching gas GAS_EC. That is, because the etching gas GAS_EC is also exposed on the second semiconductor layer SEC2 exposed through the openings OP in the process of etching the first to third conductive layers SD1 to SD3, the second semiconductor layer SEC2 may be etched. The first to third grooves EH1 to EH3 may be formed in the second semiconductor layer SEC2 exposed to the etching gas GAS_EC.

The method of manufacturing the display device according to an embodiment of the present disclosure may form the concavo-convex pattern by the openings OP and the first to third grooves EH1 to EH3 formed along a path of the light generated in (or emitted from) the active layer AL, in the process of etching the insulating layer ILD and the conductive layers SD1 to SD3, which is a process of a pixel circuit, without forming the concavo-convex pattern in a separate process, thereby securing process efficiency and increasing light emission efficiency of the light emitting element LD.

Although the present disclosure has been described with reference to embodiments thereof, those skilled in the art will understand that the present disclosure may be variously modified and changed without departing from the scope of the present disclosure described in the claims and their equivalents.

## Claims

1. A display device comprising:
a substrate;
a connection electrode on the substrate;
a light emitting element on the connection electrode and comprising a first semiconductor layer, an active layer, and a second semiconductor layer sequentially arranged in a third direction; and
an insulating layer covering the connection electrode and the light emitting element, the insulating layer having openings spaced apart from each other and exposing the second semiconductor layer of the light emitting element, and
wherein the second semiconductor layer has a plurality of grooves corresponding to the openings in the insulating layer.

2. The display device according to claim 1, wherein each of the plurality of grooves overlaps the openings in a plan view and extends through a portion of the second semiconductor layer.

3. The display device according to claim 1 or 2, wherein the openings in the insulating layer and the plurality of grooves in the second semiconductor layer form a concavo-convex pattern.

4. The display device according to claim 1, 2 or 3, further comprising:
a first transistor on the substrate and spaced apart from the light emitting element in a first direction crossing the third direction;
a first pixel electrode on the insulating layer and electrically connected to the first semiconductor layer of the light emitting element through the connection electrode; and
a second pixel electrode,
wherein the insulating layer has a contact opening exposing a portion of the second semiconductor layer in which the plurality of grooves are not formed, and
wherein the second pixel electrode is electrically connected to the second semiconductor layer of the light emitting element through the contact opening.

5. The display device according to claim 4, wherein the first pixel electrode is between the first transistor and the light emitting element, wherein the first pixel electrode does not overlap the light emitting element in a plan view, and
wherein the second pixel electrode is on the insulating layer and covers at least one side surface of the light emitting element.

6. The display device according to claim 4 or 5, further comprising:
a second power line on the same layer as the connection electrode and to which a second driving power is applied;
a first via layer covering the first transistor and the second power line;
a second conductive pattern on the first via layer and connected to the first transistor;
a second via layer on the first via layer and covering the second conductive pattern; and
a third conductive pattern on the second via layer,
wherein the third conductive pattern comprises a first power line to which first driving power is applied.

7. The display device according to any preceding claim, wherein an inner surface shape of each of the plurality of grooves is a taper shape.

8. The display device according to any preceding claim, wherein the display device further includes a conductive adhesive member between the connection electrode and the light emitting element.

9. A method of manufacturing a display device, the method comprising:
providing a substrate having a display element area and a pixel circuit area;
forming a first transistor in the pixel circuit area;
forming a connection electrode in the display element area;
forming a light emitting element by sequentially forming a first semiconductor layer, an active layer, and a second semiconductor layer on the connection electrode;
forming an insulating layer covering the first transistor, the connection electrode, and the light emitting element;
forming openings partially exposing the second semiconductor layer of the light emitting element by etching the insulating layer;
forming a first conductive layer on the first transistor; and
forming first conductive patterns by etching the first conductive layer,
wherein the forming of the first conductive patterns comprises forming first grooves in the second semiconductor layer exposed through the openings.

10. The method according to claim 9, further comprising forming a contact opening exposing the second semiconductor layer of the light emitting element by etching the insulating layer,
wherein the forming of the openings comprises forming a first contact hole and a second contact hole exposing a source electrode and a drain electrode of the first transistor, respectively, by etching the insulating layer,
wherein the first conductive patterns comprises:
a first pixel electrode electrically connected to the first semiconductor layer of the light emitting element through the connection electrode; and
a second pixel electrode electrically connected to the second semiconductor layer of the light emitting element through the contact opening.

11. The method according to claim 9 or 10, further comprising:
forming a first via layer on the first conductive patterns;
forming a second conductive layer on the first via layer; and
forming second conductive patterns by etching the second conductive layer,
wherein the forming of the second conductive patterns comprises forming second grooves in the second semiconductor layer exposed through the openings,
wherein the first grooves have a first etch depth, and
wherein the second grooves have a second etch depth deeper than the first etch depth.

12. The method according to claim 11, wherein the forming of the first conductive patterns comprises etching the first conductive layer by using an etching gas,
wherein the forming of the second conductive patterns comprises etching the second conductive layer by using the etching gas,
wherein the etching gas comprises boron trichloride (BCl₃) and chlorine (CL₂),
wherein the second conductive patterns comprise a (2-1)-th conductive pattern and a (2-2)-th conductive pattern, and
wherein the (2-1)-th conductive pattern comprises a scan line.

13. The method according to claim 12, further comprising:
forming a second via layer on the first via layer;
forming a third conductive layer on the second via layer; and
forming a third conductive pattern by etching the third conductive layer by using the etching gas,
wherein the forming of the third conductive pattern comprises forming third grooves in the second semiconductor layer exposed through the openings, and
wherein the third grooves have a third etch depth deeper than the second etch depth.

14. The method according to claim 13, wherein the third conductive pattern includes a first power line to which a first driving power is applied, and the third conductive pattern is electrically connected to a second terminal of the first transistor through the (2-2)-th conductive pattern.

15. The method according to claim 12, 13 or 14, wherein the openings in the insulating layer and the plurality of grooves in the second semiconductor layer form a concavo-convex pattern.
